# EUROPEAN PATENT SPECIFICATION

(11) **EP 1 706 887 B1**
(45) Date of publication and mention of the grant of the patent: **26.09.2012**
(21) Application number: 04775186.2
(22) Date of filing: 06.10.2004
(51) Int. Cl.: H01J 37/244

(54) **METHOD AND SYSTEM FOR THE DIRECTIONAL DETECTION OF ELECTRONS IN A SCANNING ELECTRON MICROSCOPE**
VERFAHREN UND SYSTEM ZUR GERICHTETEN DETEKTION VON ELEKTRONEN IN EINEM RASTERELEKTRONENMIKROSKOP
PROCEDE ET SYSTEME PERMETTANT LA DETECTION DIRECTIONNELLE D'ELECTRONS DANS UN MICROSCOPE ELECTRONIQUE A BALAYAGE

(30) Priority: 21.01.2004 PL 36451004
(43) Date of publication of application: 04.10.2006
(73) Proprietor: POLITECHNIKA WROCLAWSKA, 50-370 Wroclaw (PL)
(72) Inventor: SLOWKO, Witold, PL-51-627 Wroclaw (PL)
(74) Representative: Gnatzig, Klaus
(86) International application number: PCT/PL2004/000080
(87) International publication number: WO 2005/071710

(56) References cited:
- US-A- 4 588 890
- PATENT ABSTRACTS OF JAPAN vol. 015, no. 037 (P-1159), 29 January 1991 (1991-01-29) -& JP 02 275368 A (FUJITSU LTD), 9 November 1990 (1990-11-09)
- PATENT ABSTRACTS OF JAPAN vol. 012, no. 026 (E-577), 26 January 1988 (1988-01-26) -& JP 62 184752 A (JEOL LTD), 13 August 1987 (1987-08-13)
- SLOWKO W: "Directional detection of secondary electrons for electron beam profilography" VACUUM ELSEVIER UK, vol. 52, no. 4, 1999, pages 441-449, XP002316008 ISSN: 0042-207X cited in the application

## Description

The subject of the invention is the method and the system for the directional detection of electrons in a scanning electron microscope, particularly destined to obtain topographic contrast of the images of the sample surface or to enable its three dimensional reconstruction.

There are methods and systems for the directional detection of electrons known from the publication: - W. Slówko, "Directional detection of secondary electrons for electron beam profilography", Vacuum 52 (1999), s.441, PL 309904(A41) entitled "Secondary electron detection unit" and PL 31 65 01 (A1) entitled "System for signal processing in a scanning electron microscope,", no. P316499 entitled "Method of surface topography reconstruction in a scanning electron microscope", and P363131 entitled "Electron detection system for a swanning electron microscope". It consists in a symmetrical disposition of two or more electron detectors above the examined surface. Each of the detectors should collect electrons coming from another sector of the solid angle of their emission. That means that the electron detection occurs simultaneously in all the angle sectors. Signals obtained from particular detectors depend on the emission currents in the matching angle sectors, and may be used for determining the local slope angles of the surface examined and for its three dimensional reconstruction.

Then, the detection systems based on the known method of the directional electron detection are composed of two or more electron detectors disposed symmetrically around the axis of the electron beam scanning the examined surface, and a set of electrodes biased properly with constant voltages which should ensure a laminar flow of emitted electrons according to directions of their emission. In case of the backscattered electron detection, the detector system may be relatively simple and composed of two or four semiconductor diodes of the p-i-n type connected with proper amplifiers of their signals. However, the detector system for secondary electrons is much more complex. It must contain two or four complete scintillator detectors of the Everhart-Thornley type, i.e. a scintillator with its high voltage supply, a light pipe, a photomultiplier with its voltage supply and a signal amplifier for each of the two or four detector channels.

A Detection system according to the preamble of claims 1 and 9 is known from US 4,588,890 -A1. With this system two detectors are turned on in an alternating manner and the signals detected with each detector are combined to precisely determine the positions of edges on the sample.

From JP 62184752 A1 and JP 02275368 A1 additional detection systems for electron beam apparatus are known.

It is the object of the invention to provide a detection system and a method for the detection of electrons in an scanning electron microscope with which electrons emitted from a sample can be analysed according to their initial emission directions. These objects are solved with a detection system with the features of claim 1 and a method with the features of claim 9.

The substance of the method by the invention as defined in claim 9, consists in the fact, that at least two sectors for the flow of electrons detected are arranged in the detector system, and the flow of electrons in the particular sectors is opened alternatively in a proper sequence.

The substance of the system by the invention, as defined in claim 1, consists in the fact, that at least in two sectors of the electron flow from the sample stage to the scintillator, the sector flow control electrodes are placed and supplied alternatively with electric pulses. The sector flow control electrodes may be made of a metal grid and placed in the way of the electron flow from the sample stage to the scintillator.

The sector flow control electrodes may also be made of metal plates and properly placed in order not to blank off the electron flow to the scintillator.

The sector flow control electrodes may also be deposited on the microporous plate in the form of thin conductive layers. The system may contain at least two scintillators connected with the photomultiplier by means of the single light pipe or by means of two light pipes at least.

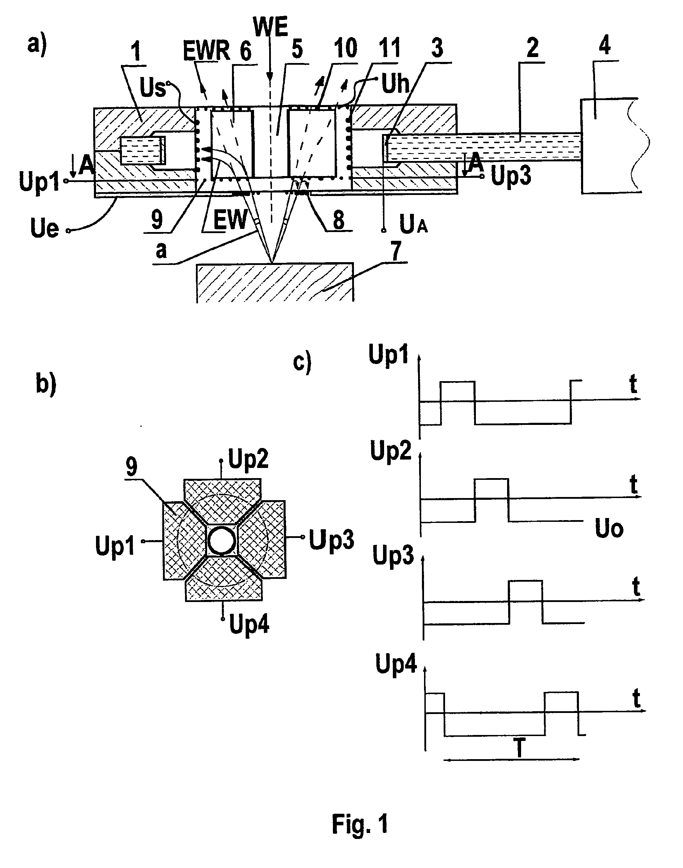

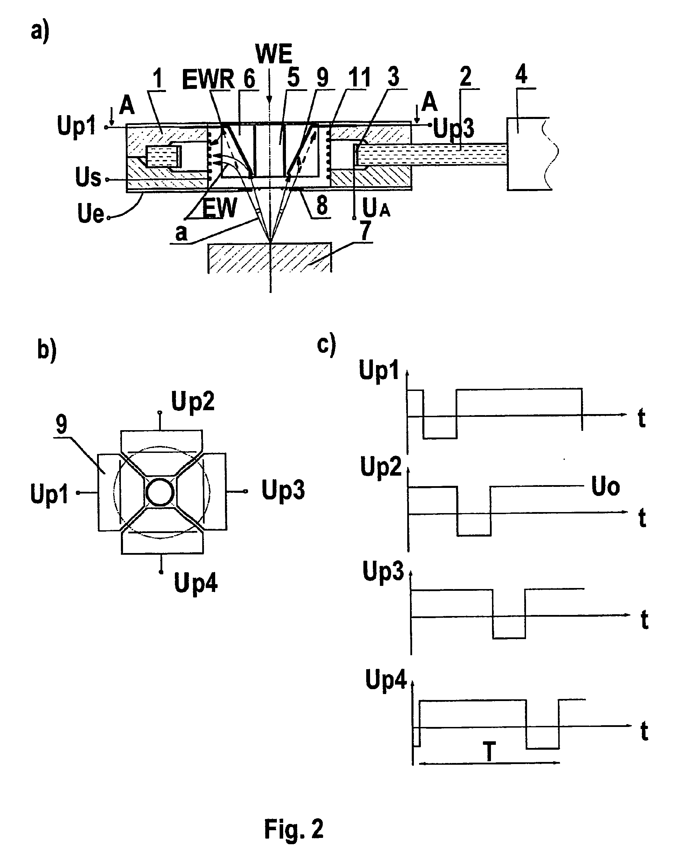

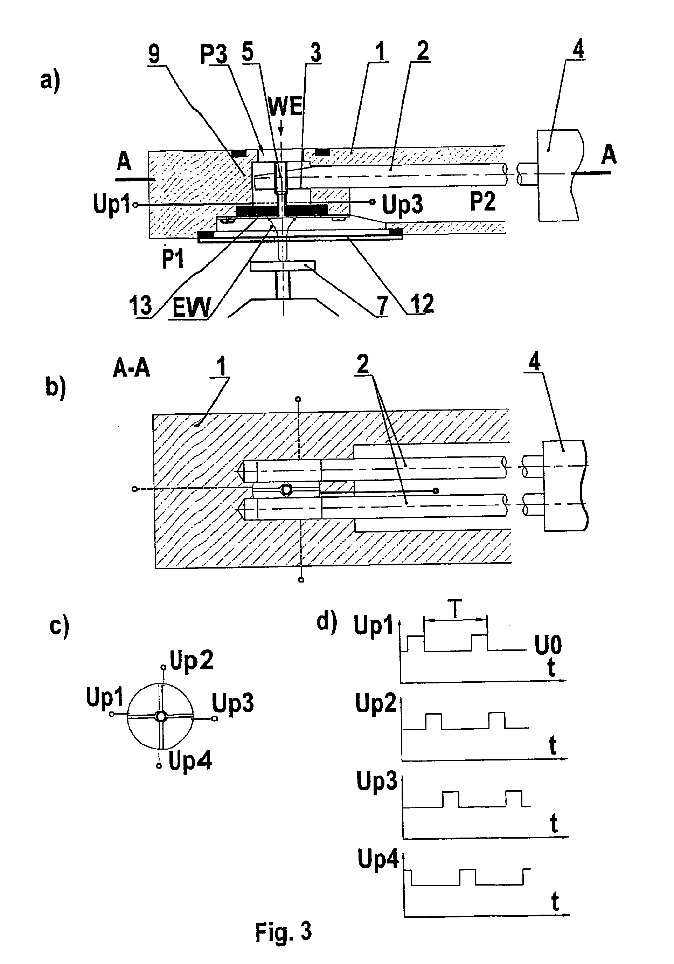

The subject of the invention in examples of realization is shown in the figures, where Fig. 1a presents the system for the directional detection of electrons in a scanning electron microscope in a vertical section, Fig. 1b - sector flow control electrodes seen from above, Fig. 1c - sequential voltage waveforms on the sector flow control electrodes, Fig. 2a presents the system for the directional detection of electrons in a scanning electron microscope in a vertical section, Fig. 2b - sector flow control electrodes seen from above, Fig. 2c - sequential voltage waveforms on the sector flow control electrodes, Fig. 3a presents the system for the directional detection of electrons in a scanning electron microscope in a vertical section, Fig. 3b - presents the system for the directional detection of electrons in a scanning electron microscope in cross section Fig. 3c - sector flow control electrodes seen from above, Fig. 3d - sequential voltage waveforms on the sector flow control electrodes.

### Example 1.

The method for directional electron detection in a scanning electron microscope, in which the flow of electrons entering the detection system is divided into four sectors. In these sectors the electron flow is opened alternatively in a given time sequence.

### Example 2.

The system for the directional detection of electrons in a scanning electron microscope shown in Fig. 1, is mounted in the ring-shaped head body 1 made of teflon. In the slot of the two-piece head body 1 the light pipe 2 is located, in form of a plexiglass plate with a hole covered with the scintillator 3 on its perimeter. The light pipe 2 is connected to the photomultiplier 4. Inside the head body 1, the screen pipe 5 is located with four screen plates 6 attached symmetrically, which divide a hole in the head body 1 into four sectors. In the lower part of the head body 1, the input grid 8 is located on the sample stage 7 side. Above the input grid 8, the four sector electron flow control electrodes 9 are located, each one placed in one sector formed between the screen plates 6. The sector flow control electrodes 9 are made of metal grid. The retarding grid 10 in the upper part screens the hole in the head body 1 while the screen grid 11 shields the slot on the hole perimeter.

The operation of the system for the directional detection of electrons in a scanning electron microscope described above is as follows.

Electron bombardment causes secondary electron EW and backscattered electron EWR emission from the surface of the examined object placed on the sample stage 7. The emitted electrons EW and EWR follow their initial directions and a fraction of them, within the vertical detection angle a, enters the detection system input window through the input grid 8. The value of this angle can be adjusted with the extraction voltage Ue. The input window is ring-shaped, because its central part is shadowed by the screen pipe 5, protecting the electron beam WE from the electric field in the detector. The detection system interior is divided into four sectors by the four screen plates 6, in which the electron flow is controlled by the four sector flow control electrodes 9. The sector flow control electrodes 9 are biased with a constant negative voltage Uo of approximately-100V, which prevents secondary electrons EW of energies lower than 100eV from entering the detection system. The retarding grid 10, located at the system outlet, is biased with a retarding voltage Uh = -50V, which causes the backscattered electrons EWR with higher energies than the lower sector flow control electrode 9 voltage Uo, to leave the system without detection. The electron stream in each sector is shielded from the scintillator 3 biased with a high positive voltage Ua = 10kV, by the screen grid 11 biased with the grid voltage Us. To sample the emission current in the first sector of the input window, a positive voltage impulse Up1, with an amplitude slightly higher than the bias voltage Uo, has to be applied to the corresponding sector flow control electrode 9. In such case all electrons emitted toward this sector will enter the detection system, however only secondary electrons EW with energies below or close to 50eV determined by the retarding grid 10 voltage, will flow to the scintillator 3. The secondary electron EW signal converted by the scintillator 3 to its light equivalent, is transferred through the light pipe 2 to the photomultiplier 4. At the photomultiplier 4 the signal is converted into its electrical form and amplified. After approximately one fourth of the sample period, the first impulse Up1 fades and the electron flow in this sector is stopped. Simultaneously, the next voltage impulse Up2 is applied to the second sector flow control electrode 9. The secondary electron EW detection process in this sector is initiated. The consecutive secondary electron EW detection phases follow in the next sectors in a given time sequence. The signals from the four detection channels are fed to a proper computer acquisition system, which sequentially samples and separates the signals. The described example of the detection system is destined for secondary electron EW detection, because the arrangement of metal grids does not stop backscattered electrons EWR.

### Example 3.

The system for the directional detection of electrons in a scanning electron microscope shown in Figure 2 is designed similarly to the previous example, and mounted in a ring-shaped head body 1 made of teflon, In the slot of the two-piece head body 1 the light pipe 2 is located, in the form of a plexiglass plate with a hole covered with the scintillator 3 on its perimeter. The light pipe 2 is connected to the photomultiplier 4. The screen pipe 5 with four screen plates 6 divides the hole in the head body 1 interior into four sectors. The input grid 8 is located in the lower part of the head body 1, on the sample stage 7 side. The four sector electron flow control electrodes 9 are located above the input grid 8 in upper part of the head body 1, each one placed in one sector formed between the screen plates 6. The sector flow control electrodes 9 are made of sheet metal plates with their ends bent towards the input grid 8. The slot in the head body 1 is shielded by the screen grid 11.

This version of the system is destined for the directional detection of backscattered electrons EWR only, or for both backscattered electrons EWR and secondary electrons EW.

The operation of the system for the directional detection of electrons in a scanning electron microscope described above is as follows.

Electron bombardment causes emission of secondary electrons EW and backscattered electrons EWR from the examined object on the sample stage 7. The emitted electrons EW and EWR follow their initial direction and a fraction of them, within the vertical detection angle a, enters the detection unit input window through the input grid 8. The value of this angle can be adjusted with the extracting voltage Ue. When Ue < -50V, only backscattered electrons EWR with higher energies enter the detection unit, while electrons of all energy fractions may pass through the grid when Ue = 0. The input window is ring-shaped, because its central part is occupied by the screen pipe 5 that protects the electron beam WE from the electric field inside the detector. The detection system interior is divided into four sectors by the four screen plates 6, in which the electron flow is controlled by the four sector flow control electrodes 9. The sector flow control electrodes 9, shown in Figure 2b, are biased with a constant positive voltage Uo of approximately +100V. In such case both backscattered electrons EWR and secondary electrons EW reach the surface of the sector flow control electrodes 9 and are collected by them. In this case, secondary electrons EW of the second type generated by the former ones cannot flow towards the scintillator 3, because the grid voltage Us of the screen grid 11 is lower than the sector flow control electrodes 9. To sample the emission current at the first sector of the input window, a negative voltage impulse Up1, with an amplitude slightly higher than the bias voltage Uo, has to be applied to the corresponding sector flow control electrode 9. In this case, secondary electrons EW of any type, either coming from the sample or emitted from the sector flow control electrode 9 can reach the scintillator 3, because the screen grid 11 voltage Us exceeds the sector flow control electrode 9 voltage. The signal multiplexing procedure proceeds as described in the former example. Secondary emission from the sector flow control electrodes 9 fulfils a crucial role in the control of the electron flow to the scintillator 3, therefore the sector flow control electrodes 9 should be made of, or coated with a material of a high secondary emission coefficient, as for instance MgO.

### Example 4.

The system for the directional detection of electrons in a scanning electron microscope shown in Figure 3 is adapted to operate in a low-vacuum scanning electron microscope. The unit is mounted in the head body 1, made of teflon. The lower throttling aperture 12 is located in the lower part of the head body 1, and formed as a metal plate with a small hole, coaxial with the electron beam WE axis. The microporous plate 13 is located above the lower throttling aperture 12. The microporous plate 13 has a hole coaxial with the electron beam WE axis, inside which the screening pipe 5 is fixed by means of a teflon seal. The lower entrance surface of the microporous plate 13 is coated with a thin conducting layer, permeable for electrons. A similar thin conducting layer present also on the upper surface of the microporous plate 13, is however divided into four independent sectors, which play the role of the sector flow control electrodes 9. Two scintillators 3 are located above the microporous plate 13, and connected with the common photomultiplier 4 by means of the two light pipes 2.

The operation of the system for the directional detection of electrons in a scanning electron microscope described above is as follows.

Secondary electrons EW, generated from the specimen on the sample stage 7, are attracted by the lower throttling aperture 12 biased with a positive voltage, and pass through the hole in this electrode. The secondary electrons EW encounter the retarding electric field on the other side of the lower throttling aperture 12, which is created by the screen pipe 5 biased negatively in relation to the lower throttling aperture 12. This forms a diverging electron lens in the region of the hole in the lower throttling aperture 12, and makes the secondary electron EW flow from the sample stage 7 to the microporous plate 13 approximately laminar. Thus, the emission direction of the secondary electrons EW implies the input sector of the microporous plate 13 they can reach. On the other side of the microporous plate 13, the conducting layer is divided into four independent sectors, which constitute the sector flow control electrodes 9 powered with constant voltage Uo and sequential voltage impulses Up1, Up2, Up3, Up4. The secondary electrons EW are multiplied by secondary emission from the walls, while passing through the micro-canals in the microporous plate 13 biased with a voltage order of 1 kV. The microporous plate 13 amplification in a given sector depends exponentially from the supply voltage. Therefore a 20% increase in the bias voltage Uo, achieved by adding the sampling impulse Up1, Up2, Up3, or Up4, is enough to make the output current in a given sector ten times higher than in the others. The amplified secondary electron EW current leaves the microporous plate 13 in the sampled sector and reaches one of the two scintillators 3, placed symmetrically at the both sides of the electron beam WE, and biased positively in relation to the microporous plate 13 with the accelerating voltage of approximately 10kV. The scintillators 3 convert the input electric current into a light equivalent. This light signal is transported through the light pipes 2 to the common photomultiplier 4, where it is converted into the output electric signal. In the discussed design, the two rod light pipes 2 of a circular cross section connected with two scintillators 3 are used, instead of one flat light pipe 2 with a annular scintillator 3. This is due to the fact, that in a low-vacuum scanning electron microscope, it is easier to seal the rod light pipes 2 in the head body 1, which separates zones of different pressures P 1, P2 and P3.

### List of designations in the Figures

1- head body,
2 - light pipe,
3 - scintillator,
4 - photomultiplier,
5 - screen pipe,
6 - screen plates,
7 - sample stage,
8 - input grid,
9 - sector flow control electrode,
10 - retarding grid,
11- screen grid,
12 - lower throttling aperture,
13 - micro-porous plate,
P 1, P2, P3 - gas pressures in various zones of the system,
EW - - secondary electrons,
EWR - backscattered electrons,
WE - electron beam,
a - vertical detection angle,
Us - grid voltage,
Ua - accelerating voltage,
Ue - extracting voltage,
Uo - bias,
Uh - retarding voltage,
Up1- first sampling pulse,
Up2 - second sampling pulse,
Up3 - third sampling pulse,
Up4 - forth sampling pulse.

## Claims

1. A system for directional detection of electrons emitted from a sample to be positioned on a sample stage in a scanning electron microscope, the system comprising a scintillator (3) and a set of control electrodes (9), wherein the control electrodes (9) are arranged to be alternatively supplied with electrical pulses to control the flow of electrons from the sample to the scintillator, **characterized in that** the scintillator (3) and the control electrodes (9) are arranged within a ring shaped head body (1), that means are provided to arrange within said head body at least two sectors op electron flow from the sample stage to the scintillator and that the control electrodes (9) are adapted to control the flow of electrons in a selected ones of said at least two sectors of electron flow to sample the emission current into the selected one of the at least two sectors so that the flow of electrons in the particular sectors is opened alternatively in a proper sequence.

2. The system of claim 1, wherein the means to arrange the at least two sectors of electron flow are screen plates (6) which divide a hole in the head body (1) into sectors.

3. The system of claim 1, wherein the means to arrange the at least two sectors of electron flow is a microporous plate (13), one surface of which is covered with a thin conducting layer divided into independent sectors.

4. The system of claim 1 or 2, wherein the control electrodes (9) are made of a metal grid.

5. The system of one of the claims 1, 2 or 4, wherein the control electrodes (9) are made of metal plates.

6. The system of one of claims 1 - 5, wherein the control electrodes (9) are placed in the way of the electron flow from the sample stage (7) to the scintillator.

7. The system of one of the claims 1 to 6, wherein at least two scintillators (3) are provided and wherein the at least two scintillators are connected to a photomultiplier (4) by a single light pipe (2).

8. The system of one of the claims 1 to 6, wherein at least two scintillators (3) are provided and wherein the at least two scintillators are connected to a photomultiplier (4) by at least two light pipes (2).

9. A method of directional detection of electrons in a scanning electron microscope comprising the steps:
- providing at least one scintillator (3),
- providing control electrodes (9), and
- supplying said control electrodes alternatively with electrical pulses to control the flow of electrons from a sample to a scintillator,
**characterized in that** the following additional steps are provided:
- providing inside a ring shaped head body (1) at least two sectors of electron flow from the sample stage to the scintillator, and
- wherein the supply of the control electrodes (9) with electrical pulses is carried out in a manner that the flow of electrons into selected ones of said at least two sectors of electron flow is controlled whereby the emission current into the selected one of the at least two sectors is sampled so that the flow of electrons in the particular sectors is opened alternatively in a proper sequence.

## Patentansprüche

1. System für die Richtungsdetektion von Elektronen, die von einer auf einer Probenbühne in einem Rasterelektronenmikroskop zu positionierenden Probe emittiert werden, wobei das System einen Szintillator (3) und eine Gruppe von Steuerelektroden (9) umfasst, wobei die Steuerelektroden (9) so angeordnet sind, dass sie abwechselnd mit elektrischen Impulsen versorgt werden, um den Strom von Elektronen von der Probe zu dem Szintillator zu steuern, **dadurch gekennzeichnet, dass** der Szintillator (3) und die Steuerelektroden (9) in einem ringförmigen Kopfkörper (1) angeordnet sind, dass Mittel vorgesehen sind, um in dem Kopfkörper wenigstens zwei Sektoren des Elektronenstroms von der Probenbühne zu dem Szintillator anzuordnen, und dass die Steuerelektroden (9) dafür ausgelegt sind, den Elektronenstrom in einem ausgewählten der wenigstens zwei Sektoren des Elektronenstroms zu steuern, um den Emissionsstrom in den ausgewählten der wenigstens zwei Sektoren abzutasten, so dass der Elektronenstrom in den bestimmten Sektoren abwechselnd in einer geeigneten Folge geöffnet wird.

2. System nach Anspruch 1, wobei die Mittel zum Anordnen der wenigstens zwei Sektoren des Elektronenstroms Gitterplatten (6) sind, die ein Loch in dem Kopfkörper (1) in Sektoren unterteilen.

3. System nach Anspruch 1, wobei die Mittel zum Anordnen der wenigstens zwei Sektoren des Elektronenstroms eine mikroporöse Platte (13) sind, wovon eine Oberfläche mit einer dünnen leitenden Schicht abgedeckt ist, die in unabhängige Sektoren unterteilt ist.

4. System nach Anspruch 1 oder 2, wobei die Steuerelektroden (9) aus einem Metallgitter hergestellt sind.

5. System nach einem der Ansprüche 1, 2 oder 4, wobei die Steuerelektroden (9) aus Metallplatten hergestellt sind.

6. System nach einem der Ansprüche 1-5, wobei die Steuerelektroden (9) in der Weise des Elektronenstroms von der Probenbühne (7) zu dem Szintillator angeordnet sind.

7. System nach einem der Ansprüche 1 bis 6, wobei wenigstens zwei Szintillatoren (3) vorgesehen sind und wobei die wenigstens zwei Szintillatoren mit einem Photovervielfacher (4) durch ein einziges Lichtrohr (2) verbunden sind.

8. System nach einem der Ansprüche 1 bis 6, wobei wenigstens zwei Szintillatoren (3) vorgesehen sind und wobei die wenigstens zwei Szintillatoren mit einem Photovervielfacher (4) durch wenigstens zwei Lichtrohre (2) verbunden sind.

9. Verfahren zur Richtungsdetektion von Elektronen in einem Rasterelektronenmikroskop, das die folgenden Schritte umfasst:
- Bereitstellen wenigstens eines Szintillators (3),
- Bereitstellen von Steuerelektroden (9) und
- Versorgen der Steuerelektroden abwechselnd mit elektrischen Impulsen, um den Strom von Elektronen von einer Probe zu einem Szintillator zu steuern,
**dadurch gekennzeichnet, dass** die folgenden weiteren Schritte vorgesehen sind:
- Bereitstellen in einem ringförmigen Kopfkörper (1) von wenigstens zwei Sektoren eines Elektronenstroms von der Probenbühne zu dem Szintillator und
- wobei die Versorgung der Steuerelektroden (9) mit elektrischen Impulsen in der Weise ausgeführt wird, dass der Elektronenstrom in ausgewählte der wenigstens zwei Sektoren des Elektronenstroms gesteuert wird, wobei der Emissionsstrom in die ausgewählten der wenigstens zwei Sektoren abgetastet wird, so dass der Elektronenstrom in die besonderen Sektoren abwechselnd in einer geeigneten Folge geöffnet werden.

## Revendications

1. Système permettant une détection directionnelle d'électrons émis depuis un échantillon à positionner sur une plaquette à échantillon dans un microscope électronique à balayage, le système comprenant un scintillateur (3) et un ensemble d'électrodes de commande (9), dans lequel les électrodes de commande (9) sont disposées pour être alimentées alternativement avec des impulsions électriques afin de commander le flux d'électrons à partir de l'échantillon vers le scintillateur, **caractérisé en ce que** le scintillateur (3) et les électrodes de commande (9) sont agencés à l'intérieur d'une tête en forme d'anneau (1), c'est-à-dire qu'ils sont prévus pour agencer à l'intérieur de ladite tête au moins deux secteurs de flux d'électrons à partir de la plaquette à échantillon vers le scintillateur et que les électrodes de commande (9) sont conçues pour commander le flux d'électrons dans l'un sélectionné desdits au moins deux secteurs de flux d'électrons pour échantillonner le courant d'émission dans celui sélectionné des au moins deux secteurs de telle sorte que le flux d'électrons dans les secteurs particuliers soit ouvert alternativement selon une séquence convenable.

2. Système selon la revendication 1, dans lequel les moyens pour agencer les au moins deux secteurs de flux d'électrons sont des plaques formant écran (6) qui divisent un alésage pratiqué dans la tête (1) en secteurs.

3. Système selon la revendication 1, dans lequel le moyen pour agencer les au moins deux secteurs de flux d'électrons est une plaque microporeuse (13), dont une surface est recouverte d'une couche mince conductrice divisée en secteurs indépendants.

4. Système selon la revendication 1 ou 2, dans lequel les électrodes de commande (9) sont constituées d'une grille métallique.

5. Système selon l'une des revendications 1, 2 ou 4, dans lequel les électrodes de commande (9) sont constituées de plaques métalliques.

6. Système selon l'une des revendications 1 à 5, dans lequel les électrodes de commande (9) sont placées sur le trajet du flux d'électrons provenant de la plaquette à échantillon (7) vers le scintillateur.

7. Système selon l'une des revendications 1 à 6, dans lequel au moins deux scintillateurs (3) sont prévus et dans lequel les au moins deux scintillateurs sont reliés à un photomultiplicateur (4) par un tube lumineux unique (2).

8. Système selon l'une des revendications 1 à 6, dans lequel au moins deux scintillateurs (3) sont prévus et dans lequel les au moins deux scintillateurs sont reliés à un photomultiplicateur (4) par au moins deux tubes lumineux (2).

9. Procédé permettant une détection directionnelle d'électrons dans un microscope électronique à balayage comprenant les étapes consistant à :
- procurer au moins un scintillateur (3),
- procurer des électrodes de commande (9), et
- alimenter alternativement lesdites électrodes de commande avec des impulsions électriques afin de commander le flux d'électrons depuis un échantillon vers un scintillateur,
**caractérisé en ce que** les étapes supplémentaires suivantes sont prévues :
- procurer à l'intérieur d'une tête en forme d'anneau (1) au moins deux secteurs de flux d'électrons à partir de la plaquette à échantillon vers le scintillateur, et
- dans lequel l'alimentation des électrodes de commande (9) avec des impulsions électriques est effectuée de manière telle que le flux d'électrons dans celui sélectionné desdits au moins deux secteurs de flux d'électrons est commandé grâce à quoi le courant d'émission dans celui sélectionné des au moins deux secteurs est échantillonné de telle sorte que le flux d'électrons dans les secteurs particuliers soit ouvert alternativement selon une séquence convenable.
